# EUROPEAN PATENT SPECIFICATION

(11) **EP 2 383 366 B1**
(45) Date of publication and mention of the grant of the patent: **22.04.2015**
(21) Application number: 09839289.7
(22) Date of filing: 28.12.2009
(51) Int. Cl.: C23C 16/27, C23C 16/515, H01L 21/31, H01L 21/205

(54) **METHOD FOR PRODUCING DIAMOND-LIKE CARBON MEMBRANE**
VERFAHREN ZUR HERSTELLUNG EINER MEMBRAN AUS DIAMANTÄHNLICHEM KOHLENSTOFF
PROCÉDÉ DE PRODUCTION D'UNE MEMBRANE EN CARBONE DE TYPE DIAMANT

(30) Priority: 28.01.2009 JP 2009016935
(43) Date of publication of application: 02.11.2011
(73) Proprietor: Kabushiki Kaisha Kobe Seiko Sho, Chuo-ku Kobe-shi Hyogo 651-8585 (JP)
(72) Inventor: Hirotaka ITO, Kobe-shi, Hyogo 651-2271 (JP); Kenji YAMAMOTO, Kobe-shi, Hyogo 651-2271 (JP)
(74) Representative: Müller-Boré & Partner Patentanwälte PartG mbB
(86) International application number: PCT/JP2009/071803
(87) International publication number: WO 2010/087102

(56) References cited:
- EP-A1- 0 962 550
- EP-A1- 1 619 265
- EP-A2- 1 627 934
- JP-A- 2007 070 667
- US-A1- 2004 038 033

## Description

The present invention relates to a method for producing a diamond-like carbon (DLC, amorphous carbon) film. Specifically, the present invention relates to a method for stable and high-speed formation of a diamond-like carbon film. The resulting diamond-like carbon film is applied to the surfaces of sliding portions of sliding members, such as automotive cams and shims, which slide over surfaces between two parts in contact with each other, or it is applied typically to electronic parts as a surface modification treatment to improve electrical properties of the parts.

A diamond-like carbon film (DLC film) has a composite structure being intermediate between diamond and graphite, thereby has high hardness, and excels in wear resistance, solid lubricity, thermal conductivity, and chemical stability as with diamond The DLC film, therefore, is now being used as a protective film for various parts such as sliding members, dies, cutting tools, wear-resistant mechanical parts, abrasive materials, and magnetic/optical parts.

Preparation processes for the DLC film are roughly classified as two categories, i.e., physical vapor deposition (PVD) and chemical vapor deposition (CVD). Deposition by PVD enables the preparation of coating films which contain none or small amount of hydrogen and thereby have a high hardness by using no hydrocarbon gas or by minimizing the amount of the gas to be introduced upon deposition. The coating films, when formed on the surfaces of sliding parts, allow the sliding parts to have higher durability. For example, Patent Literature (PTL) 1 discloses the formation of a DLC formed article by PVD, which DLC formed article includes first and second DLC films and an intermediate layer therebetween and excels in adhesion to the substrate and in wear resistance. The deposition by PVD, however, cannot be said as excelling in productivity because of low deposition rate of 1 micrometer per hour (µm/h) or less.

In contrast, deposition by CVD is advantageous in that this process shows a deposition rate higher than that of PVD process and enables coating on an intricately-shaped material As just described, the CVD process may be performed at a higher deposition rate, but an apparatus for use in CVD should have a devised configuration so as to perform stable deposition at such a high deposition rate. Typically, PTL 2 describes that an auxiliary electrode is provided to apply an electric field uniformly to an intricately-shaped substrate, in order to perform film deposition uniformly at high speed even using such an intricately-shaped substrate. Specifically, PTL 2 discloses a technique which mainly focuses on coating to an intricately-shaped substrate and which performs film deposition on the inner wall of the substrate by providing an auxiliary electrode corresponding to the shape of the sample (substrate). The technique, however, requires the modification (alternation) of the apparatus so as to provide an auxiliary electrode and should use different auxiliary electrodes corresponding to the shapes of substrates. Accordingly, the technique disclosed in PTL 2 is not intended to enable high-speed and stable deposition of a DLC film with a relatively simple apparatus which has been customarily used.

PTL 1: Japanese Unexamined Patent Application Publication (JP-A) No. 2007-70667
PTL 2: Japanese Unexamined Patent Application Publication (JP-A) No. 2002-363747

US 2004/0038033 A1 discloses a process for producing a diamond-like carbon (DLC) film on a specific layer system, which comprises the step of applying a DLC or diamond layer on a transition layer by means of plasma-supported deposition of carbon from the gaseous phase, wherein a substrate biasing voltage is applied to the substrate during said process step and the plasma is stabilized by means of a magnetic field during said process step, and wherein acetylene is used as reaction gas.

The present invention has been made under such circumstances, and an object of the present invention is to provide a method which enables stable and high-speed formation of a DLC film by a CVD process, especially by plasma CVD, using a general-purpose apparatus without needing significant modification of the apparatus.

The present invention provides, in an aspect, a method for producing a diamond-like carbon film, which method includes the step of forming a diamond-like carbon film on or above a substrate by plasma chemical vapor deposition, in which the step of forming the diamond-like carbon film includes applying a bipolar pulsed direct-current voltage to the substrate; feeding a gas containing toluene into a chamber; controlling a total gas pressure in the chamber at 4 Pa or more and 7 Pa or less; and controlling a negative bias voltage in the bipolar pulsed direct-current voltage to have a magnitude of 400 V or more and 650 V or less.

In a preferred embodiment, the gas to be fed into the chamber is a gaseous mixture of toluene and argon, and the gaseous mixture has a volume fraction of toluene of 40% or more.

In another preferred embodiment, an electroconductive material is arranged around the substrate, and the electroconductive material is grounded.

The bipolar pulsed direct-current voltage preferably has a pulse frequency of 200 kHz or more.

In a preferred embodiment, the method includes the steps of forming an underlayer on the substrate in the chamber by physical vapor deposition; and forming the diamond-like carbon film on the underlayer in the same chamber by plasma chemical vapor deposition. The underlayer herein is preferably formed from a component generated from an unbalanced magnetron sputtering source through physical vapor deposition.

The present invention enables stable and high-speed deposition of a DLC film by plasma CVD using a general-purpose apparatus without needing significant modification of the apparatus. In particular, the method enables the deposition of a DLC film without needing a high ambient pressure (total gas pressure of gases in the atmosphere) unlike customary plasma CVD techniques. The method may employ a composite apparatus composed of a customary PVD apparatus as in PTL 1, except for being added with a plasma CVD function, and in this case, the method enables the deposition of a DLC film in a chamber of the composite apparatus without needing significant modification of the exhaust system of the apparatus. In addition, the method enables stable and high-speed deposition of a DLC film and deposition of another film (e.g., an underlayer to be formed between the substrate and DLC film) than the DLC film by PVD. in one apparatus in a simple manner.

[Fig. 1] Fig. 1 is a drawing illustrating an exemplary pulse wave pattern of a bipolar pulsed direct-current voltage.
[Fig. 2] Fig. 2 is a schematic explanatory drawing of an apparatus used in working examples for the deposition of DLC films.
[Fig. 3] Fig. 3 depicts graphs, by hydrocarbon gas type, of the deposition rate as a function of the total gas pressure.
[Fig. 4] Fig. 4 is a graph of the deposition rate as a function of the volume fraction of toluene in the gaseous mixture.
[Fig. 5] Fig. 5 is a graph of the deposition rate as a function of the pulse frequency of the bipolar pulsed direct-current voltage.
[Fig. 6] Fig. 6 is a graph of the deposition rate as a function of the magnitude of a negative bias voltage in the bipolar pulsed direct-current voltage.

The present inventors made various investigations on deposition conditions to perform stable and high-speed deposition of DLC films by plasma CVD using a general-purpose apparatus (vacuum chamber) without needing significant modification of the apparatus. As a result, the present inventors have found that this can be achieved by using a bipolar pulsed direct-current voltage as a voltage to be applied to a substrate; employing a toluene-containing gas as a gas to be fed into a chamber, and controlling a total gas pressure in the chamber at 4 Pa or more and 7 Pa or less. The deposition conditions specified in the present invention will be described in detail below.

First, a bipolar pulsed direct-current voltage is used herein as a voltage to be applied to the substrate.

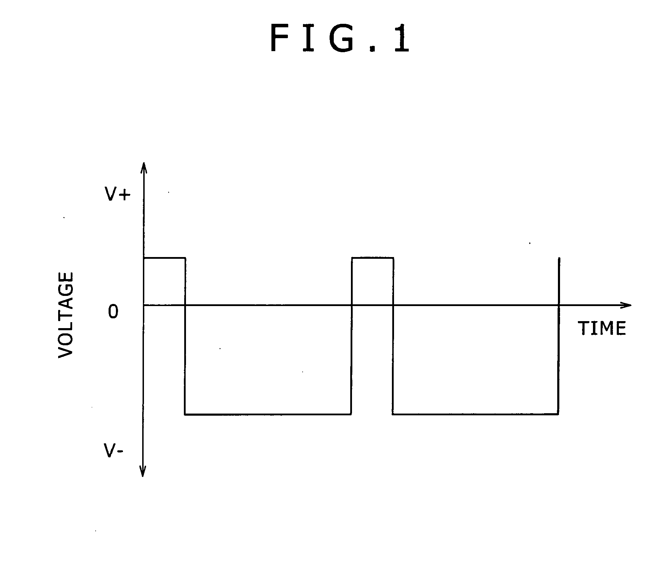

For the deposition of DLC films by plasma CVD, a high-frequency power source is generally used as a power source. The high-frequency power source, however, shows a varying self-bias upon use which varies depending on the load and shape of the sample (substrate). The deposition conditions herein should be optimized corresponding to such a varying self bias, because arbitrary control of the self bias is impossible. In contrast, a direct-current (DC) power source does not cause problems unlike the high-frequency power source and is advantageous in industrial applications. The direct-current power source, however, needs the modification of the chamber or should be designed to have a large scale, because an ambient pressure and a power at certain levels or higher are required to start direct-current discharge. In contrast, according to the present invention, a bipolar pulsed direct-current voltage is applied to the substrate, and this accelerates the motion of electrons. Specifically, when a negative bias voltage or positive bias voltage is applied, electrons reciprocate between the substrate and a counter electrode thereon i.e., a chamber inner wall or an electroconductive material mentioned later. The acceleration of electron motion increases the ionization efficiency. As a result, the starting of discharge herein does not need such a high ambient pressure and power at certain levels or higher, but stable deposition can be performed even at lower ambient pressures and with lower powers. As used herein the term "bipolar pulsed direct-current voltage" refers to a voltage, in which both positive and negative voltage pulses appear alternately on time axis, and includes both the case where a positive pulse wave pattern and a negative pulse wave pattern are symmetrical to each other and the case where these wave patterns are asymmetric. The positive pulse wave pattern and the negative pulse wave pattern are preferably asymmetric, because this further increases the ionization efficiency, and the deposition can be started under a further lower ambient pressure with a further lower power and can be performed at further higher speed. In this case, the time-integrated value of the negative bias voltage is preferably larger than the time-integrated value of the positive bias voltage in the bipolar pulsed direct-ærrent voltage The concrete wave pattern of the pulse is not specified herein, and, for example, the pulse may have an asymmetric wave pattern as illustrated in Fig. 1.

As has been described above, a bipolar pulsed direct-current voltage is applied to the substrate to increase the ionization efficiency, and this also increases the deposition rate. In addition, the use of such pulsed voltage allows the frequency and duty cycle (being constant at 50% in the high-frequency power source) of the applied voltage, and this enables wide-range control of the deposition rate and properties of the film. The control of the deposition rate and other factors as above may be particularly effectively performed when a toluene-containing gas is used as a gas to be fed into the chamber.

A DLC film is formed by introducing a gas containing a hydrocarbon gas (carbon-containing gas) into the chamber, applying a voltage to the substrate, and decomposing the hydrocarbon gas to deposit the vapor of DLC onto the substrate.

The present inventors made investigations on the type of the hydrocarbon gas and have found that toluene ("toluene" refers to one in a gaseous state; hereinafter the same) is optimum as the hydrocarbon gas. As is demonstrated in working examples mentioned later, the total gas pressure little affects the deposition rate when the deposition is performed using a gas containing methane or acetylene as the hydrocarbon gas. In contrast, a deposition rate of more than 10 micrometers per hour (µm/h) may be achieved when the deposition is performed using a gas containing toluene. Thus, toluene, when used in deposition, provides a higher deposition rate than those in other hydrocarbon gases. This is probably because toluene has an ionization energy (8.82 eV) smaller than that of methane (12.98 eV) and that of acetylene (11.41 eV).

In a preferred embodiment, a gaseous mixture of toluene and argon is used as the gas to be fed into the chamber, and toluene occupies 40 percent by volume or more of the gaseous mixture (i.e., the gaseous mixture has a volume fraction of toluene of 40% or more). By ensuring a sufficient amount of toluene to be decomposed in the above manner, the deposition rate may be further increased. The volume fraction of toluene is more preferably 45% or more. In contrast, toluene, if contained in an excessively high volume fraction, may cause unstable plasma to thereby cause unstable deposition. To avoid this, the gaseous mixture for use herein has a volume fraction of toluene of preferably 60% or less, and more preferably 55% or less.

The total gas pressure in the chamber is controlled to be 4 Pa or more and 7 Pa or less according to the present invention. The deposition rate can be increased by increasing the total gas pressure in the chamber. As is demonstrated in the after-mentioned working examples, the total gas pressure is controlled to be 4 Pa or more for achieving such a high deposition rate of more than 10 µm/h. The total gas pressure is preferably 4.5 Pa or more. In contrast, gases, if present in an excessively high total pressure, may cause the plasma to be unstable, and this may impede the deposition. To avoid this, the total gas pressure is controlled to be 7 Pa or less herein. The total gas pressure is preferably 6.5 Pa or less.

In a preferred embodiment, the deposition is performed while an electroconductive material is arranged around the substrate where the electroconductive material is grounded. According to this embodiment, the electroconductive material shows electroconductivity as its name suggests, and is grounded. This allows the chamber and the electroconductive material to have an identical potential to each other, and the surface of the electroconductive material serves as a counter electrode with respect to the sample (substrate). This means that the counter electrode approaches the sample to thereby allow the plasma to be generated in a higher density, resulting in a further increased deposition rate.

Examples of the electroconductive material include stainless steels (SUS) and titanium alloys, and the electroconductive material may be in the form of a plate or woven wire. The electroconductive material may have any shape not critical, as long as facing the substrate at a certain spacing, and may be in the form typically of substantially circular cylinder, elliptic cylinder, or polygonal cylinder. The spacing (distance) between the substrate and the surface of the electroconductive material (e.g., cylindrical electroconductive material) is preferably 30 mm or more and 100 mm or less.

The bipolar pulsed direct-current voltage in the deposition has a pulse frequency of preferably 200 kHz or more, and more preferably 230 kHz or more, for reliably ensuring a higher deposition rate. Independently, the bipolar pulsed direct-current voltage has a pulse frequency of preferably 300 kHz or less, because the bipolar pulsed direct-current voltage, if having a pulse frequency of more than 300 kHz, may not give a stable plasma, and this may cause the deposition to be unstable. The bipolar pulsed direct-current voltage more preferably has a pulse frequency of 260 kHz or less for further improving the deposition rate and for further ensuring deposition stability.

The negative bias voltage in the bipolar pulsed direct-current voltage has a magnitude of 400 V or more, and preferably 500 V or more, for further reliably increasing the deposition rate. In contrast, the negative bias voltage has a magnitude of 650 V or less, because the negative bias voltage, if having a magnitude of more than 650 V, may impede stable plasma generation and may cause the deposition to be unstable.

The method according to the present invention may be carried out in an existing plasma CVD apparatus but may also be carried out by forming a DLC film through plasma CVD in a chamber for PVD use. Typically, a DLC film may be formed by plasma CVD in a chamber of a composite apparatus corresponding to a PVD apparatus (e.g., sputtering apparatus), except for being added with a plasma CVD function.

In the sputtering apparatus (PVD apparatus), evacuation with a rotary pump or turbo-molecular pump is generally performed For this reason, there is required significant modification of the exhaust system, such as an extra evacuation line as independently provided, when a DLC film is to be deposited in a chamber of the PVD apparatus at a high total gas pressure in the atmosphere of 10 Pa or more, according to customary plasma CVD techniques. However, the method according to the present invention enables the deposition of a DLC film at an ambient pressure (total gas pressure in the atmosphere) of less than 10 Pa and thereby allows high-speed and stable formation of a DLC film by plasma CVD even using a chamber for PVD use.

The deposition of a DLC film in the composite apparatus has such an advantage that the deposition of a DLC film by plasma CVD and the deposition of another film than the DLC film by PVD can be performed in one chamber. Examples of the other film include a metal layer or metallic compound layer as described typically in PTL 1, as an underlayer to be formed between the substrate and the DLC film.

In a concrete embodiment, an underlayer is formed on the substrate by PVD in a chamber, and subsequently, a DLC film is formed on the underlayer by plasma CVD under the specific conditions in the same chamber.

In the PVD process, the underlayer is preferably formed from a component generated from an unbalanced magnetron sputtering source (sputtering evaporation source), for the formation of a dense and highly hard coating film as the underlayer.

The present invention will be illustrated in further detail with reference to several working examples below.

### EXAMPLES

### (EXPERIMENTAL EXAMPLE 1)

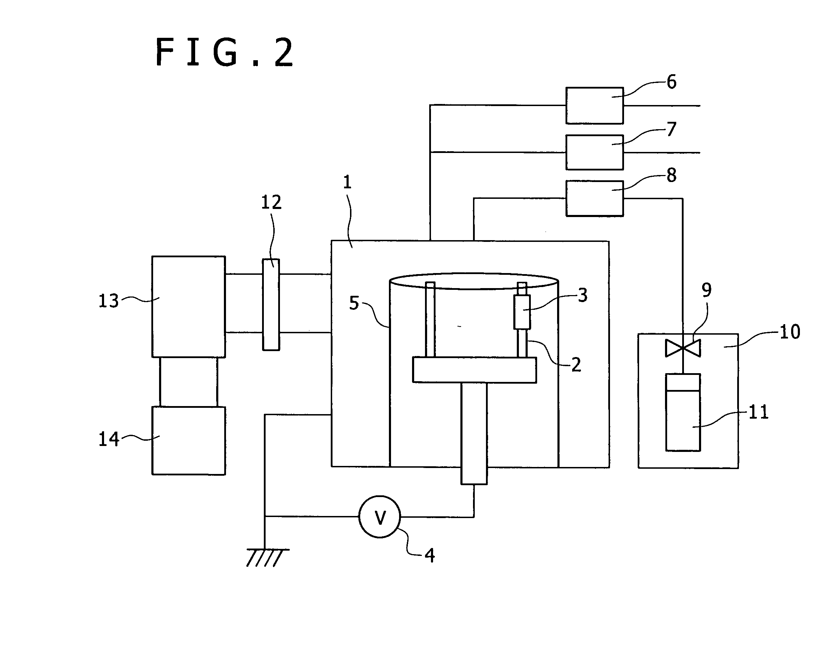

With reference to Fig. 2, a chamber 1 of an unbalanced magnetron sputter apparatus UBMS 202 supplied by Kabushiki Kaisha Kobe Seiko-Sho (Kobe Steel, Ltd) was used herein. In the chamber, a substrate 3 was surrounded by a cylinder made from an electroconductive material (cylindrical electroconductive material or electroconductive cylinder) 5. The deposition of a DLC film was performed by plasma CVD while applying a pulsed direct-current bias voltage to the substrate 3. In Fig. 2, the reference sign "2" stands for a substrate supporter. A power source 4 was an asymmetric pulsed direct-current power source (Pinnacle (registered trademark) Plus+ supplied by Advanced Energy Industries, Inc. (AE), 5-kW power source) and was connected to a substrate stage. The pulse duty cycle was constant at 70%, and the pulse width was set suitably for the deposition. A bipolar pulsed direct-current voltage herein had a pulse frequency of 250 kHz and included a negative bias voltage having a magnitude of 600 V. The cylindrical electroconductive material 5 was one made of stainless steel sheet, was arranged so that the surface of the electroconductive cylinder was at a distance of 75 mm from the surface of the sample, and was grounded.

A gaseous mixture of Ar (argon) and C₇H₈ (toluene) was used as a gas to be fed into the chamber. As illustrated in Fig. 2, toluene was heated to 70°C in a thermostat 10, and simultaneously with this, evacuation was performed, and toluene was thereby evaporated and introduced into the chamber 1. In Fig. 2, the reference sign "11" stands for a liquid toluene reservoir, and the reference sign "9" stands for a valve. In addition, depositions were also performed as comparative examples in the same manner as above, except for introducing acetylene or methane instead of toluene. The volume fractions of toluene, acetylene, and methane in the gaseous mixtures with argon were each set to be constant at 50%. In Fig. 2, reference sign "6" stands for an argon-massflow controller, the reference sign "7" stands for a methane/acetylene-massflow controller, and the reference sign "8" stands for a toluene-massflow controller.

A silicon wafer (silicon substrate) was used as the substrate 3. The substrate 3 was introduced into the chamber 1, and the evacuation was performed to a pressure of 1x10⁻³ Pa or less before deposition. In addition, deposition processes were performed at different total gas pressures in the chamber 1. The total gas pressure was controlled by regulating the open/close quantity of a manual butterfly valve 12. In Fig. 2, the reference sign "13" stands for a turbo-molecular pump, and the reference sign "14" stands for a rotary pump.

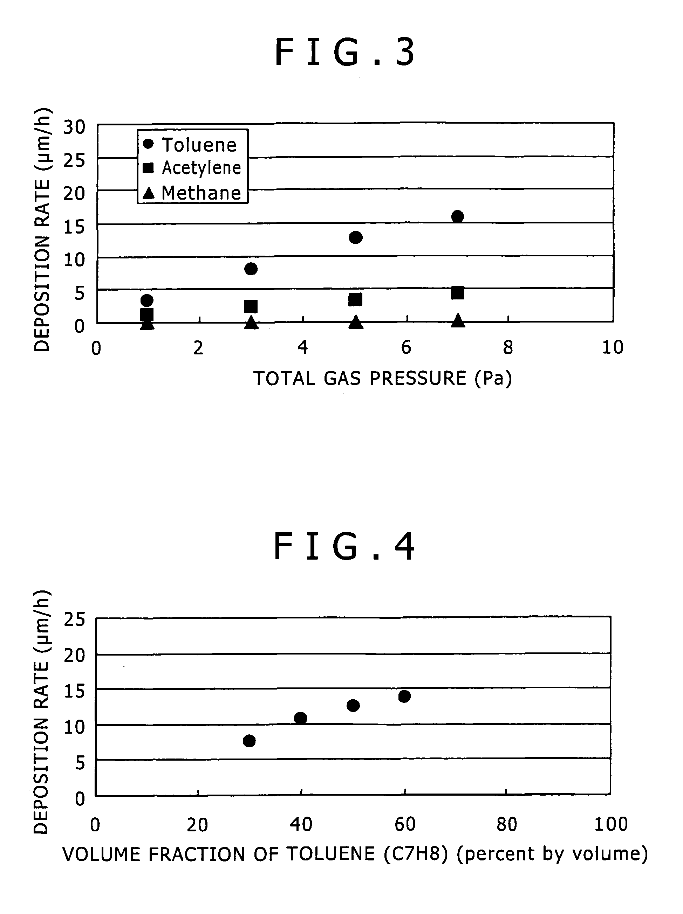

The deposition rate was determined by applying collection fluid onto the silicon wafer for masking, candying out deposition of a film, thereafter removing the collection fluid, and measuring the difference in level between the film surface and the substrate surface with a surface profiler (DEKTAK). The results by hydrocarbon gas type are shown in Table 1. In addition, based on data in Table 1, graphs by hydrocarbon gas type were plotted and are shown in Fig. 3, which graphs show how the deposition rate varies depending on the total gas pressure.

**[Table 1]**

| Total gas pressure (Pa) | Deposition rate (µm/h) | | |
|---|---|---|---|
| | Toluene | Acetylene | Methane |
| 1 | 3.38 | 1.12 | 0.054 |
| 3 | 8.02 | 2.32 | 0.067 |
| 5 | 12.58 | 323 | 0.083 |
| 7 | 15.7 | 4.3 | 0.117 |

Table 1 and Fig. 3 demonstrate that the deposition rate increases in proportional to an increasing total gas pressure when any hydrocarbon gas was used. However, the deposition using acetylene proceeded at a low deposition rate of 4.3 µm/h even at a high total gas pressure of 7 Pa, being lower than the deposition rate (15.7 µm/h) of the deposition using toluene performed at the identical total gas pressure. The deposition using methane proceeded at a deposition rate of about 0.1 µm/h even at a high total gas pressure of 7 Pa, demonstrating that this deposition proceeds at very low deposition rates. Independently, a stable deposition was not performed at a total gas pressure of 8 Pa or more even when toluene was used In the experiment, a non-pulsed direct-current power source was also used, but it failed to generate plasma and failed to perform film deposition. The non-pulsed direct-current power source failed to initiate discharge even at a high voltage of 1000 V under total gas pressures in the range as employed in the experiment, indicating that the discharge inception voltage herein is probably higher than 1000 V.

### (EXPERIMENTAL EXAMPLE 2)

An experiment was performed to investigate how the quantity (volume fraction) of toluene in the gaseous mixture affects the deposition rate.

Specifically, depositions of DLC films were performed by the procedure of Experimental Example 1, except for using gaseous mixtures of toluene and argon with different volume fractions of toluene, and performing deposition at a constant total gas pressure in the chamber of 5 Pa. The deposition rates were determined by the procedure of Experimental Example 1. The results are shown in Table 2. In addition, based on data in Table 2, a graph was plotted and is shown in Fig. 4, which graph shows how the deposition rate varies depending on the volume fraction of toluene in the gaseous mixture.

**[Table 2]**

| Volume fraction of toluene (C₇H₈) | Deposition rate |
|---|---|
| (percent by volume) | (µm/h) |
| 30 | 7.54 |
| 40 | 10.7 |
| 50 | 12.58 |
| 60 | 13.75 |

Table 2 and Fig. 4 demonstrate that the deposition rate increases with an increasing quantity (volume fraction) of toluene in the gaseous mixture and that the volume fraction of toluene in the gaseous mixture is preferably 40% or more for reliably increasing the deposition rate to 10 µm/h or more.

### (EXPERIMENTAL EXAMPLE 3)

An experiment was performed to investigate how the presence or absence of an electroconductive material to be arranged around the substrate affects the deposition rate.

Specifically, depositions of DLC films were performed by the procedure of Experimental Example 1, except for using a gaseous mixture of toluene (volume fraction: 50%) and argon, setting the total gas pressure in the chamber at a constant pressure of 5 Pa, and performing deposition with or without the cylindrical electroconductive material. Deposition rates in the respective deposition processes were determined by the procedure of Experimental Example 1.

As a result, the deposition without the cylindrical electroconductive material proceeded at a deposition rate of 7.17 µm/h, whereas the deposition with the cylindrical electroconductive material proceeded at a deposition rate of 12.58 µm/h. This demonstrates that the arrangement of the cylindrical electroconductive material increases the deposition rate to about 1.8 times. This is probably because the surface of the cylindrical electroconductive material having an identical potential to the chamber serves as a counter electrode with respect to the sample, the arrangement of the cylindrical electroconductive material makes the counter electrode nearer to the sample, and this increases the plasma density to thereby improve the deposition rate, as has been described above.

### (EXPERIMENTAL EXAMPLE 4)

An experiment was performed to investigate how the pulse frequency of the bipolar pulsed direct-current voltage affects the deposition rate in deposition.

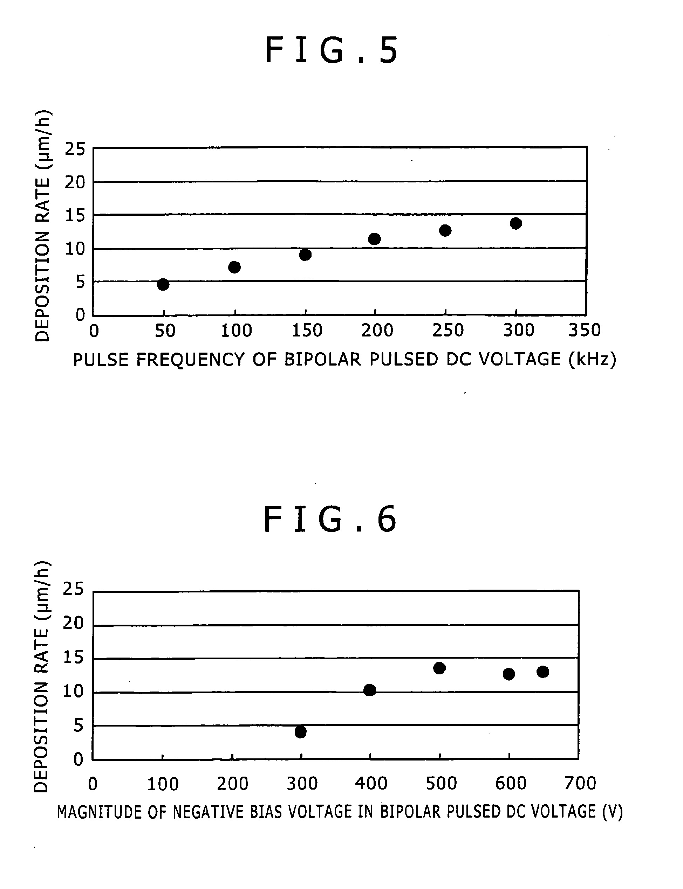

Specifically, depositions ofDLC films were performed by the procedure of Experimental Example 1, except for using a gaseous mixture of toluene (volume fraction: 50%) and argon, setting the total gas pressure in the chamber at a constant pressure of 5 Pa, and performing deposition at different pulse frequencies of the bipolar pulsed direct-current voltage in the range of from 50 to 300 kHz. Deposition rates in the respective deposition processes were determined by the procedure of Experimental Example 1. The results are shown in Table 3. Based on the data in Table 3, a graph was plotted and is shown in Fig. 5, which graph shows how the deposition rate varies depending on the pulse frequency of the bipolar pulsed direct-current voltage.

**[Table 3]**

| Pulse frequency of bipolar pulsed direct-curent voltage | Deposition rate |
|---|---|
| (kHz) | (µm/h) |
| 50 | 4.58 |
| 100 | 7.02 |
| 150 | 8.79 |
| 200 | 112 |
| 250 | 1258 |
| 300 | 13.5 |

Table 3 and Fig. 5 demonstrate that the deposition rate increases with an increasing pulse frequency of the bipolar pulsed direct-current voltage, and that deposition at a deposition rate of 10 µm/h or more can be achieved at a pulse frequency of the bipolar pulsed direct-current voltage of 200 kHz or more, which deposition rate is higher than the deposition rate (1 µm/h or less) in DLC film deposition through PVD by one order or more.

### (EXPERIMENTAL EXAMPLE 5)

An experiment was performed to investigate how the magnitude of the negative bias voltage in the bipolar pulsed direct-current voltage affects the deposition rate in deposition.

Specifically, depositions of DLC films were performed by the procedure of Experimental Example 1, except for using a gaseous mixture of toluene (volume fraction: 50%) and argon, setting the total gas pressure in the chamber at a oonstant pressure of 5 Pa, and performing deposition at different magnitudes in the range of from 300 to 650 V of the negative bias voltage in the bipolar pulsed direct-current voltage. Deposition rates in the respective deposition processes were determined by the procedure of Experimental Example 1. The results are shown in Table 4. In addition, based on data in Table 4, a graph was plotted and is shown in Fig. 6, which graph shows how the deposition rate varies depending on the magnitude of the negative bias voltage in the bipolar pulsed direct-current voltage.

**[Table 4]**

| Magnitude of negative bias voltage in bipolar pulsed direct-cument voltage | Deposition rate |
|---|---|
| (V) | (µm/h) |
| 300 | 3.92 |
| 400 | 10.06 |
| 500 | 13.4 |
| 600 | 12.58 |
| 650 | 12.8 |

Table 4 and Fig. 6 demonstrate that the deposition rate increases with an increasing magnitude of the negative bias voltage in the range of from 300 to 500 V in the bipolar pulsed direct-current voltage, and that deposition at a deposition rate of 10 µm or more can be achieved by performing the deposition at a magnitude of the negative bias voltage of 400 V or more. Table 4 and Fig. 6 also demonstrate that the deposition rate becomes nearly flat at magnitudes of negative bias voltage of more than 500 V.

### Reference Signs List

- 1: chamber
- 2: substrate supporter
- 3: sample (substrate)
- 4: power source
- 5: cylindrical electroconductive material
- 6: argon-massflow controller
- 7: methane/acetylene-massflow controller
- 8: toluene-massflow controller
- 9: valve
- 10: thermostat
- 11: liquid toluene reservoir
- 12: butterfly valve
- 13: turbo-molecular pump
- 14: rotary pump

## Claims

1. A method for producing a diamond-like carbon film, the method comprising the step of forming a diamond-like carbon film on or above a substrate by plasma chemical vapor deposition,
wherein the step of forming the diamond-like carbon film includes:
applying a bipolar pulsed direct-current voltage to the substrate;
feeding a gas containing toluene into a chamber;
controlling a total gas pressure in the chamber at 4 Pa or more and 7 Pa or less; and
controlling a negative bias voltage in the bipolar pulsed direct-current voltage to have a magnitude of 400 V or more and 650 V or less.

2. The method for producing a diamond-like carbon film, according to claim 1, wherein the gas to be fed into the chamber is a gaseous mixture of toluene and argon, and the gaseous mixture has a volume fraction of toluene of 40% or more.

3. The method for producing a diamond-like carbon film, according to claim 1, wherein an electroconductive material is arranged around the substrate, and the electroconductive material is grounded.

4. The method for producing a diamond-like carbon film, according to claim 1, wherein the bipolar pulsed direct-current voltage has a pulse frequency of 200 kHz or more.

5. The method for producing a diamond-like carbon film, according to claim 1, wherein the method comprises the steps of forming an underlayer on the substrate in the chamber by physical vapor deposition; and forming the diamond-like carbon film on the underlayer in the same chamber by plasma chemical vapor deposition.

6. The method for producing a diamond-like carbon film, according to claim 5, wherein the underlayer is formed from one or more components generated from an unbalanced magnetron sputtering source through physical vapor deposition.

7. The method for producing a diamond-like carbon film, according to claim 1, wherein the diamond-like carbon film is formed at a deposition rate of more than 10 micrometers per hour (µm/h).

## Patentansprüche

1. Verfahren zur Herstellung eines diamantartigen Köhlenstofffilms, wobei das Verfahren den Schritt des Bildens eines diamantartigen Kohlenstofffilms auf oder über einem Trägermaterial mittels chemischer Plasmagasphasenabscheidung umfasst,
wobei der Schritt des Bildens des diamantartigen Kohlenstofffilms enthält:
das Anlegen eines bipolar gepulsten Gleichstroms an das Trägermaterial,
das Einleiten eines toluolhaltigen Gases in eine Kammer,
das Regeln eines Gesamtgasdrucks in der Kammer auf 4 Pa oder mehr und 7 Pa oder weniger und
das Regeln einer negativen Vorspannung in dem bipolar gepulsten Gleichstrom auf eine Stärke von 400 V oder mehr und 650 V oder weniger.

2. Verfahren zur Herstellung eines diamantartigen Kohlenstofffilms nach Anspruch 1, wobei das in die Kammer einzuleitende Gas ein Gasgemisch aus Toluol und Argon ist und das Gasgemisch einen Volumenanteil an Toluol von 40% oder mehr aufweist.

3. Verfahren zur Herstellung eines diamantartigen Kohlenstofffilms nach Anspruch 1, wobei ein elektrisch leitendes Material um das Trägermaterial angeordnet ist und das elektrisch leitende Material geerdet ist.

4. Verfahren zur Herstellung eines diamantartigen Kohlenstofffilms nach Anspruch 1, wobei der bipolar gepulste Gleichstrom eine Pulsfrequenz von 200 kHz oder mehr aufweist.

5. Verfahren zur Herstellung eines diamantartigen Kohlenstofffilms nach Anspruch 1, wobei das Verfahren die Schritte des Bildens einer Unterschicht auf dem Trägermaterial in der Kammer mittels physikalischer Gasphasenabscheidung und des Bildens des diamantartigen Kohlenstofffilms auf der Unterschicht in derselben Kammer mittels chemischer Plasmagasphasenabscheidung umfaßt.

6. Verfahren zur Herstellung eines diamantartigen Kohlenstofffilms nach Anspruch 5, wobei die Unterschicht gebildet wird aus einer oder mehrerer Komponenten, erzeugt von einer ungleichmäßigen Magnetronsputterquelle, mittels physikalischer Gasphasenabscheidung.

7. Verfahren zur Herstellung eines diamantartigen Kohlenstofffilms nach Anspruch 1, wobei der diamantartige Kohlenstofffilm mit einer Abscheidungsgeschwindigkeit von mehr als 10 Mikrometern pro Stunde (µm/h) gebildet wird.

## Revendications

1. Procédé de production d'un film de carbone de type diamant, le procédé comprenant l'étape de formation d'un film de carbone de type diamant sur ou au-dessus d'un substrat par dépôt chimique en phase vapeur assisté par plasma,
dans lequel l'étape de formation d'un film de carbone de type diamant comporte :
l'application d'une tension continue pulsée bipolaire sur le substrat ;
l'introduction d'un gaz contenant du toluène dans une chambre ;
la commande d'une pression totale de gaz dans la chambre à une valeur supérieure ou égale à 4 Pa et inférieure ou égale à 7 Pa ; et
la commande d'une tension de polarisation négative sur la tension continue pulsée bipolaire de manière à obtenir une amplitude supérieure ou égale à 400 V et inférieure ou égale à 650 V.

2. Procédé de production d'un film de carbone de type diamant, selon la revendication 1, dans lequel le gaz à introduire dans la chambre est un mélange gazeux de toluène et d'argon, et le mélange gazeux présente une fraction volumique de toluène supérieure ou égale à 40%.

3. Procédé de production d'un film de carbone de type diamant, selon la revendication 1, dans lequel un matériau électriquement conducteur est agencé autour du substrat, et le matériau électriquement conducteur est mis à la masse.

4. Procédé de production d'un film de carbone de type diamant, selon la revendication 1, dans lequel la tension continue pulsée bipolaire présente une fréquence d'impulsion supérieure ou égale à 200 kHz.

5. Procédé de production d'un film de carbone de type diamant, selon la revendication 1, dans lequel le procédé comprend les étapes de formation d'une sous-couche sur le substrat dans la chambre par dépôt physique en phase vapeur ; et de formation d'un film de carbone de type diamant sur la sous-couche dans la même chambre par dépôt chimique en phase vapeur assisté par plasma.

6. Procédé de production d'un film de carbone de type diamant, selon la revendication 5, dans lequel la sous-couche est formée par un ou plusieurs composants générés à partir d'une source de pulvérisation à magnétron asymétrique par dépôt physique en phase vapeur.

7. Procédé de production d'un film de carbone de type diamant, selon la revendication 1, dans lequel le film de carbone de type diamant est formé à une vitesse de dépôt supérieure à 10 micromètres par heure (µm/h).
